# EUROPEAN PATENT SPECIFICATION

(11) **EP 1 038 791 B1**
(45) Date of publication and mention of the grant of the patent: **18.07.2007**
(21) Application number: 00301755.5
(22) Date of filing: 03.03.2000
(51) Int. Cl.: B65D 71/50

(54) **Container carrier**
Behälterträger
Porte-récipients

(30) Priority: 16.03.1999 US 268478
(43) Date of publication of application: 27.09.2000
(73) Proprietor: ILLINOIS TOOL WORKS INC., Glenview, Illinois 60025-5811 (US)
(72) Inventor: Olsen, Robert, Medinah, IL 60157 (US)
(74) Representative: Finnie, Peter John

(56) References cited:
- EP-A- 0 453 122
- US-A- 4 219 117
- US-A- 5 456 350

## Description

This invention relates to a carrier for unitizing a plurality of uniform containers having multiple possible container diameters.

Carriers according to this invention connect two or more containers into a sturdy unitized package of containers. Carriers are generally planar arrays of rings, sometimes referred to as "six-pack carriers", typically formed from a thermoplastic sheet material. Carriers are applied to containers of various sizes and shapes. One important consideration in the design of a carrier is the adaptability of the carrier to such sizes and shapes. A cost-effective carrier is capable of application to a wide range of container sizes and configurations.

Many containers on the market have distinguishing characteristics to assist in marketing and brand identity. For instance, cans have various configurations of body diameters and chime diameters. When a can has an unusual ratio between the body diameter and the chime diameter, conventional carriers may not properly unitize a plurality of such cans without significant modification.

US-A-4219117 discloses a multipackaging device.

EP-A-0453122 discloses a cup carrier.

US-A-05456350 discloses a carrier stock having finger-gripping straps and strut-producing straps.

According to a first aspect of the invention, there is provided a carrier for unitizing a plurality of containers, the carrier comprising:
a sheet of resilient polymeric material having a plurality of container receiving apertures aligned in opposing transverse pairs, each container receiving aperture having a small radius defining an apex at an interior edge of the container receiving aperture;
a transverse web positioned between each opposing transverse pair of container receiving apertures; and
a plurality of apertures positioned in the sheet, each aperture being positioned in the transverse web between each apex of opposing transverse pairs of container receiving apertures,
characterised by the apertures being circular or elongated in the transverse direction.

A carrier for unitizing and carrying a plurality of containers according to one preferred embodiment of this invention is used in connection with cans. The carrier according to this invention is particularly suited for application to cans having a variety of chime diameters, body diameters and/or contours.

The carrier According to this invention is preferably formed from a sheet of flexible material, such as plastic. The apertures are preferably of a generally triangular shape. The container receiving apertures may be sized to stretchingly engage with a plurality of containers to form a unitized package.

The transverse web may provide a transverse connection between each transversely adjacent container in the package.

Owing to the plurality of apertures' being positioned in the sheet so that each aperture is positioned in the transverse web between each apex of the opposing transverse pairs of container receiving apertures, a bridge may be thus formed in the transverse web between each apex of the container receiving aperture and each extremity of the elongated aperture.

According to a second aspect of the invention, there is provided a method for packaging a plurality of containers using a carrier formed from a sheet of resilient polymeric material, the method comprising:
forming a plurality of container receiving apertures aligned in opposing transverse pairs in the sheet, each container receiving aperture having a small radius defining an apex at an interior edge of the container receiving aperture and a transverse web positioned between each opposing transverse pair of container receiving apertures;
determining an appropriate length of an aperture based upon a diameter of each container of the plurality of containers; and,
forming a plurality of the apertures in the sheet, such that each aperture is positioned in the transverse web between each apex of opposing transverse pairs of container receiving apertures,
characterised by forming the apertures such that they are circular or elongated in the transverse direction.

In a method for packaging a plurality of containers according to a preferred embodiment of the invention, the appropriate length and/or width of the apertures is predetermined based upon the contour and/or diameter(s) of each container in the package, such that, when the carrier is engaged with a plurality of containers, the apertures permit the transverse webs in the carrier to stretch slightly depending upon the container contour and/or diameter.

Thus this invention provides a carrier for unitizing and maintaining proper spacing among a plurality of containers having a range of possible body diameters, chime diameters and body contours.

The carrier can be used for unitizing a plurality of containers but does not require multiple carrier stamping dies to manufacture a variety of carriers for multiple container configurations, merely a minor modification to change the size of the aperture.

A particular embodiment in accordance with this invention will now be described with reference to the accompanying drawings; wherein:-
Fig. 1 is a top view of a carrier;
Fig. 2 is a perspective view of a package of containers;
Fig. 3 is a top view of the package shown in Fig. 2.

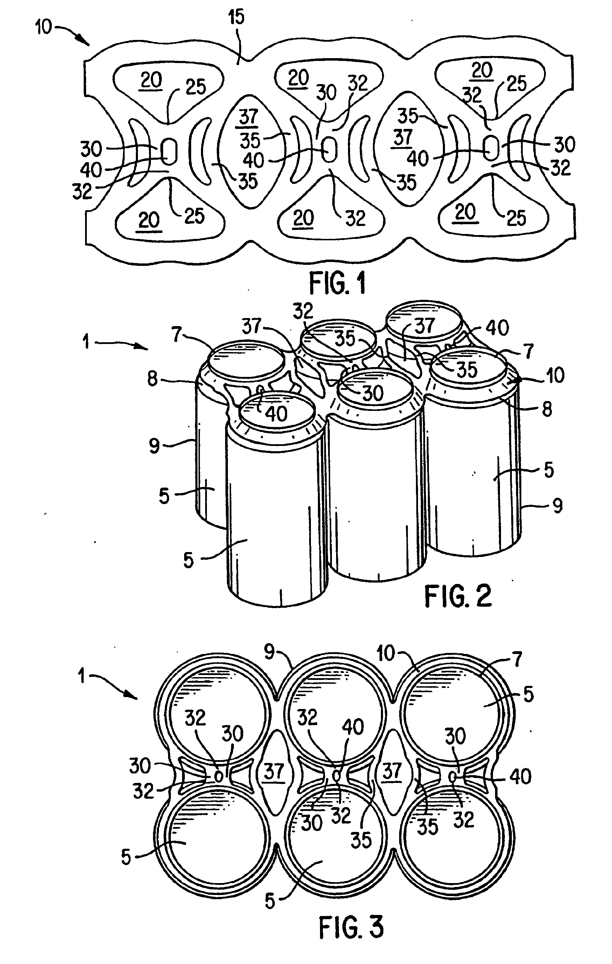

Fig. 1 shows carrier 10 for carrying a plurality of containers 5. "Containers" as used in the Specification and Claims may include cans, bottles, jars and other packages known to those having ordinary, skill in the art, however, cans, such as shown in Figs. 2 and 3, are especially suited for use in connection with carrier 10 according to this invention. Cans typically comprise chime 7, a generally vertical body 9 and a sloped transition portion 8 between chime 7 and the generally vertical body 9. Containers 5 are preferably like-sized within a single carrier 10.

Carrier 10 unitizes a plurality of containers 5 to create package 1, such as package 1 shown in Figs. 2 and 3. Sheet 15 is preferably constructed from a flexible, resilient material such as plastic. In one preferred embodiment of this invention, sheet 15 is made from low- to medium-density polyethylene.

Sheet 15 of material is preferably cut, using means known to those skilled in the art, such as a stamping die, to form a plurality of container receiving apertures 20 in sheet 15. Container receiving apertures 20 are preferably sized to stretchingly engage with containers 5 to form package 1. In one preferred embodiment of this invention, shown in Figs. 1-3, container receiving apertures 20 are formed in two longitudinal rows and three lateral ranks resulting in six container receiving apertures 20. Container receiving apertures 20 may be arranged in any other feasible arrangement of longitudinal rows and lateral ranks preferred by consumers and merchandisers.

Container receiving apertures 20 are preferably aligned in opposing transverse pairs. Each container receiving aperture 20 in the opposing transverse pair has a small radius defining apex 25 at an interior edge of container receiving aperture 20. As a result, each container receiving aperture 20 is preferably configured in a generally triangular shape as shown in Fig. 1.

Transverse web 30 is preferably positioned between each opposing transverse pair of container receiving apertures 20. Transverse web 30 provides a transverse connection and stabilization between each transversely adjacent container 5 in package 1.

According to this invention, a plurality of elongated apertures 40 are positioned in sheet 15. Each elongated aperture 40 is positioned in transverse web 30 between each apex 25 of the opposing transverse pairs of container receiving apertures 20. Bridge 32 is formed in transverse web 30 between each extremity of elongated aperture 40 and apex 25 of each container receiving aperture 20.

As shown in Figs. 1-3, elongated aperture 40 is elongated in the transverse direction. In one embodiment of this invention, a radius of each elongated aperture 40 is approximately equal to the small radius of apex 25 of container receiving aperture 40. In another embodiment of this invention, aperture 40 may comprise a circular aperture.

In addition to providing desired stretching characteristics of transverse web 30 in carrier 10, elongated apertures 40 also reduce the weight and required material in each carrier 10. Such weight and material reduction is especially beneficial when, as here, the performance of carrier 10 is enhanced.

As shown in Figs. 1-3, carrier 10 preferably further comprises a plurality of finger straps 35 and access apertures 37 for convenient portability of package 1. As shown in Fig. 1, access apertures 37 are preferably formed in sheet 15 between transverse pairs of container receiving apertures 20 and between longitudinally adjacent pairs of container receiving apertures 20. Finger straps 3 5 are preferably formed on opposite longitudinal sides of access apertures 37.

In a method for packaging a plurality of containers 5 using carrier 10 as described above, an appropriate length and/or width of elongated aperture 40 is predetermined based upon one or more factors. A critical factor for determining the appropriate length of elongated aperture 40 is a diameter of chime 7 and a diameter of body 9 of each container 5 in package 1. As the diameter of body 9 increases and the diameter of chime 7 remains constant, transverse web 30 must stretch a greater amount. Transverse web 30 stretches a greater amount as a transverse width of bridge 32 in transverse web 30 is reduced. Therefore, an increase in a transverse length of elongated aperture 40 permits greater stretching in transverse web 30.

As the transverse width of bridge 32 is reduced, apex 25 stretches a greater amount around a perimeter of chime 7. This stretching results in a smoother interface between chime 7 and container receiving aperture 20. Such a smoother interface results in a better aesthetic appearance of package 1.

In one preferred embodiment of this invention, the length and/or width of aperture 40 may be adjusted by using an appropriate insert in a stamping die. As the length of aperture 40 is increased, the transverse width of bridge 32 decreases a corresponding amount. Carrier 10 may then be stamped into the proper configuration using the stamping die having the appropriate insert.

After forming elongated aperture 40 having the appropriate length within sheet 15, carrier 10 is engaged with a plurality of containers 5. Each container receiving opening 20 is preferably engaged with each container 5 so that transverse web 30 is permitted to stretch slightly because of elongated aperture 40.

Without the inclusion of an appropriately sized elongated aperture 40, transverse web 30 may buckle or bunch up between transversely adjacent containers 5. Elongated aperture 40 promotes appropriate stretching of transverse web 30 between transversely adjacent containers 5, thus resulting in a smooth transverse web 30 and a more aesthetically pleasing carrier 10 and package 1.

In addition, elongated aperture 40 results in proper spacing between containers 5 in a transverse direction. If transverse web 30 is too tight between transversely adjacent containers 5, bottoms of containers 5 may splay outward, thus resulting in a defective package 1. Elongated apertures 40 permit a slight stretch in transverse web 30 that avoids package 1 having splayed containers 5. As elongated aperture 40 approaches a circular configuration, transverse spacing between adjacent containers 5 will be maintained for containers 5 having larger body 9 diameters.

## Claims

1. A carrier (10) for unitizing a plurality of containers (5), the carrier (10) comprising:
a sheet of resilient polymeric material having a plurality of container receiving apertures (20) aligned in opposing transverse pairs, each container receiving aperture (20) having a small radius defining an apex (25) at an interior edge of the container receiving aperture (20) ;
a transverse web (30) positioned between each opposing transverse pair of container receiving apertures; and
a plurality of apertures (40) positioned in the sheet, each aperture (40) being positioned in the transverse web between each apex (25) of opposing transverse pairs of container receiving apertures (20),
**characterised by** the apertures (40) being circular or elongated in the transverse direction.

2. A carrier (10) according to claim 1, wherein a radius of each circular, or of each end of each elongated, aperture is approximately equal to the small radius of the apex (25).

3. A carrier according to claim 1 or claim 2, wherein the container receiving apertures are configured in a substantially triangular shape.

4. A method for packaging a plurality of containers (5) using a carrier (10) formed from a sheet of resilient polymeric material, the method comprising:
forming a plurality of container receiving apertures (20) aligned in opposing transverse pairs in the sheet, each container receiving aperture (20) having a small radius defining an apex (25) at an interior edge of the container receiving aperture (20) and a transverse web (30) positioned between each opposing transverse pair of container receiving apertures (20);
determining an appropriate length of an aperture (40) based upon a diameter of each container (5) of the plurality of containers; and,
forming a plurality of the apertures (40) in the sheet, such that each aperture (40) is positioned in the transverse web (30) between each apex (25) of opposing transverse pairs of container receiving apertures (20),
**characterised by** forming the apertures (40) such that they are circular or elongated in the transverse direction.

5. A method according to claim 4, further comprising engaging each container receiving opening (20) of the plurality of container receiving openings to each container (5) of the plurality of containers.

6. A method according to claim 4 or claim 5, further comprising reducing a transverse width of a bridge (30) between the apex (25) and an extremity of the aperture (40) to increase stretching engagement between the transverse web and each container (5).

7. A method according to any of claims 4 to 6, further comprising maintaining equivalent transverse spacing between containers (5) having different body diameters based upon the length of the apertures (40).

## Patentansprüche

1. Träger (10) zum Bilden einer Einheit aus mehreren Behältern (5), wobei der Träger (10) Folgendes umfasst:
ein Flächengebilde aus elastischem polymeren Material, das mehrere Behälteraufnahmeöffnungen (20) aufweist, die in einander gegenüberliegenden Paaren ausgerichtet sind, wobei jede Behälteraufnahmeöffnung (20) einen kleinen Radius aufweist, der an einem Innenrand der Behälteraufnahmeöffnung (20) einen Scheitel (25) definiert;
einen Quersteg (30), der zwischen jedem einander gegenüberliegenden Querpaar von Behälteraufnahmeöffnungen positioniert ist; und
mehrere Öffnungen (40), die im Flächengebilde ausgebildet sind, wobei jede Öffnung (40) im Quersteg zwischen jedem Scheitel (25) einander gegenüberliegender Paare Behälteraufnahmeöffnungen (20) positioniert ist,
**dadurch gekennzeichnet, dass** die Öffnungen (40) kreisförmig oder länglich in Querrichtung sind.

2. Träger (10) nach Anspruch 1, bei dem ein Radius jeder kreisförmigen oder jedes Endes jeder länglichen Öffnung ungefähr gleich dem kleinen Radius des Scheitels (25) ist.

3. Träger nach Anspruch 1 oder 2, bei dem die Behälteraufnahmeöffnungen in einer im Wesentlichen dreieckigen Form konfiguriert sind.

4. Verfahren zum Verpacken von mehreren Behältern (5) unter Verwendung eines Trägers (10), der aus einem Flächengebilde aus elastischem polymeren Material gebildet ist, wobei das Verfahren Folgendes umfasst:
Bilden mehrerer Behälteraufnahmeöffnungen (20) ausgerichtet in einander gegenüberliegenden Querpaaren im Flächengebilde, wobei jede Behälteraufnahmeöffnung (20) einen kleinen Radius, der an einem Innenrand der Behälteraufnahmeöffnung (20) einen Scheitel (25) definiert, und einen Querstegs (30), der zwischen jedem gegenüberliegenden Querpaar von Behälteraufnahmeöffnungen (20) positioniert ist, aufweist; und
Bestimmen einer geeigneten Länge einer Öffnung (40) auf Grundlage eines Durchmessers jedes Behälters (5) der mehreren Behälter; und
Bilden mehrerer Öffnungen (40) im Flächengebilde derart, dass jede Öffnung (40) im Quersteg (30) zwischen jedem Scheitel (25) einander gegenüberliegender Paare Behälteraufnahmeöffnungen (20) positioniert ist,
**gekennzeichnet durch** derartiges Formen der Öffnungen (40), dass sie kreisförmig oder länglich in Querrichtung sind.

5. Verfahren nach Anspruch 4, das weiterhin Ineingriffbringen jeder Behälteraufnahmeöffnung (20) der mehreren Behälteraufnahmeöffnungen mit jedem Behälter (5) der mehreren Behälter umfasst.

6. Verfahren nach Anspruch 4 oder 5, das weiterhin Verringern der Querbreite einer Brücke (30) zwischen dem Scheitel (25) und einem Ende der Öffnung (40) zum Verstärken des Dehneingriffs zwischen dem Quersteg und jedem Behälter (5) umfasst.

7. Verfahren nach einem der Ansprüche 4 bis 6, das weiterhin das Aufrechterhalten eines äquivalenten Querabstands zwischen Behältern (5) mit unterschiedlichen Körperdurchmessern auf Grundlage der Länge der Öffnungen (40) umfasst.

## Revendications

1. Support (10) pour réunir une pluralité de récipients (5), le support (10) comprenant:
une feuille de matériau polymère élastique ayant une pluralité d'ouvertures (20) recevant des récipients, alignées par paires transversales opposées, chaque ouverture (20) recevant des récipients ayant un petit rayon définissant un sommet (25) au niveau d'un bord intérieur de l'ouverture (20) recevant des récipients ;
une bande transversale (30) positionnée entre chaque paire transversale opposée d'ouvertures recevant des récipients ; et
une pluralité d'ouvertures (40) positionnées dans la feuille, chaque ouverture (40) étant positionnée dans la bande transversale entre chaque sommet (25) de paires transversales opposées d'ouvertures (20) recevant des récipients,
**caractérisé en ce que** les ouvertures (40) sont circulaires ou allongées dans la direction transversale.

2. Support (10) selon la revendication 1, dans lequel un rayon de chaque ouverture circulaire, ou de chaque extrémité de chaque ouverture allongée est approximativement égal au petit rayon du sommet (25).

3. Support selon la revendication 1 ou 2, dans lequel les ouvertures recevant des récipients sont configurées avec une forme substantiellement triangulaire.

4. Procédé d'emballage d'une pluralité de récipients (5) en utilisant un support (10) formé à partir d'une feuille de matériau polymère élastique, le procédé comprenant :
la formation d'une pluralité d'ouvertures (20) recevant des récipients, alignées par paires transversales opposées dans la feuille, chaque ouverture (20) recevant des récipients ayant un petit rayon définissant un sommet (25) au niveau d'un bord intérieur de l'ouverture (20) recevant des récipients et d'une bande transversale (30) positionnée entre chaque paire transversale opposée d'ouvertures (20) recevant des récipients ;
la détermination d'une longueur appropriée d'une ouverture (20) sur la base d'un diamètre de chaque récipient (5) de la pluralité de récipients ; et
la formation d'une pluralité des ouvertures (40) dans la feuille, de telle sorte que chaque ouverture (40) soit positionnée dans la bande transversale (30) entre chaque sommet (25) de paires transversales opposées d'ouvertures (20) recevant des récipients,
**caractérisé par** la formation des ouvertures (40) de telle sorte qu'elles soient circulaires ou allongées dans la direction transversale.

5. Procédé selon la revendication 4, comprenant en outre l'engagement de chaque ouverture (20) recevant des récipients de la pluralité d'ouvertures recevant des récipients avec chaque récipient (5) de la pluralité de récipients.

6. Procédé selon la revendication 4 ou 5 comprenant en outre la réduction d'une largeur transversale d'un pont (30) entre le sommet (25) et une extrémité de l'ouverture (40) pour augmenter l'engagement d'étirage entre la bande transversale et chaque récipient (5).

7. Procédé selon l'une quelconque des revendications 4 à 6, comprenant en outre le maintien d'un espacement transversal équivalent entre des récipients (5) ayant des diamètres de corps différents sur la base de la longueur des ouvertures (40).
